# FASCICULE DE BREVET EUROPEEN

(11) **EP 0 598 633 B1**
(45) Date de publication et mention de la délivrance du brevet: **07.01.1999**
(21) Numéro de dépôt: 93402532.1
(22) Date de dépôt: 14.10.1993
(51) Int. Cl.: H01L 21/00

(54) **Système de manipulation et de confinement d'objets plats dans des boîtes individuelles**
Handhabungssystem und Verfahren für flache Gegenstände in Einzelbehältern
Handling and processing system for workpieces in individual boxes

(30) Priorité: 16.10.1992 FR 9212422
(43) Date de publication de la demande: 25.05.1994
(73) Titulaire: COMMISSARIAT A L'ENERGIE ATOMIQUE, 75015 Paris (FR)
(72) Inventeur: Doche, Claude, F-38640 Claix (FR)
(74) Mandataire: Dubois-Chabert, Guy

(56) Documents cités:
- EP-A- 0 273 791
- EP-A- 0 412 945
- WO-A-92/02950
- DE-A- 2 626 528
- US-A- 4 715 764
- US-A- 4 717 461
- US-A- 5 100 276
- PATENT ABSTRACTS OF JAPAN vol. 7, no. 148 (E-184) (1293) 29 Juin 1983 & JP-A-58 060 555 (MITSUBISHI ELECTRIC CORP) 11 Avril 1983
- IBM TECHNICAL DISCLOSURE BULLETIN., vol.35, no.6, Novembre 1992, NEW YORK US pages 62 - 63

## Description

### DOMAINE DE L'INVENTION

L'invention concerne la fabrication, la préparation et le traitement d'objets plats, tels que des plaques de silicium, sous atmosphère spéciale et ultrapropre. Les plaques de silicium concernées sont utilisées pour la fabrication des circuits intégrés dans le domaine de l'électronique et de la microélectronique. D'autres applications peuvent être envisagées, notamment sous vide.

### ART ANTERIEUR ET PROBLEME POSE

La fabrication des circuits électroniques sur des plaques circulaires de silicium nécessite que ces dernières soient traitées sous atmosphère spéciale, manipulées et stockées sous atmosphère ultrapropre, c'est-à-dire entourées d'air très pur ou d'azote contrôlé. On utilise jusqu'alors plusieurs concepts de systèmes.

Un premier concept consiste à mettre le local où sont traitées ces plaques de silicium sous l'atmosphère ultrapropre en question, c'est-à-dire sous atmosphère contrôlé. Il s'ensuit d'imposantes installations d'aération de filtration de l'air et un équipement vestimentaire sophistiqué pour chacun des opérateurs intervenants dans le local.

Un autre concept consiste à mettre sous atmosphère contrôlée simplement les endroits où sont stockées et manipulées les plaques de silicium. Il s'agit donc des postes de travail et des conteneurs de stockage. Le transport des plaques d'un poste de travail à un autre ou d'un poste de stockage à un poste de travail se fait par l'intermédiaire de conteneurs équipés de cassettes comprenant un rayonnage permettant d'emmener entre dix et trente plaques de silicium entreposées les unes sur les autres. Ces conteneurs, en général étanches, peuvent même être équipés de leur propre système d'alimentation d'air ultrapropre.

Du document US-A-4 715 764 un système de manipulation de plaques sous basse pression est connu. Des boîtes individuelles pour des plaques sont connues du document WO-A-9 202 950.

Le but de l'invention est de proposer un autre concept de système de manipulation des plaques de silicium.

On ajoute que ces plaques de silicium s'apparente, concernant la fragilité et les conditions de traitement, à des disques optiques vidéo et des disques audionumériques compacts.

### RESUME DE L'INVENTION

L'objet principal de l'invention est donc un système de manipulation d'objets plats confinés sous atmosphère ultrapropre dans des boîtes individuelles pour amener les objets à l'intérieur d'au moins un poste de travail en assurant la continuité parfaite des objets où se trouve une atmosphère spéciale. Un tel système comprend :
- des boîtes individuelles étanches dans lesquelles se trouve une atmosphère ultrapropre ;
- des moyens de déplacement de ces boîtes dans une atmosphère ordinaire ;
- des interfaces entre les moyens de déplacement et les postes de travail des objets plats dans lesquels les boîtes sont ouvertes et les objets plats sont extraits des boîtes et sont maintenus sous atmosphère ultrapropre pendant toute la durée où ils restent à l'intérieur des équipements de travail ;
- des tunnels de déplacement des objets plats pour raccorder de façon rigide deux postes de travail tout en maintenant ces objets sous atmosphère ultra-propre ; et
- des moyens de gestion et de commande de déplacement des boîtes.

La boîte individuelle est extraplate et possède une porte escamotable.

L'interface comprend :
- un corps constituant une veine d'accès équipé d'un robot du type "pick and place" pour l'insertion des objets et agissant à l'intérieur de cette veine pour faire traverser cette veine à un objet ;
- une embase d'adaptation fixée à une première extrémité du corps et comprenant des moyens de fixation adaptés à ceux de la sortie d'un poste de travail, assurant le positionnement mécanique de l'interface par rapport au poste de travail ; et
- une embase modulaire pour positionner les boîtes, les ouvrir et permettre au robot de saisir les objets, ainsi que pour assurer les opérations inverses.

Dans ce cas, le corps comprend de préférence des moyens de protection des objets alimentés par arrivée d'air ultrapropre ou d'azote.

L'embase d'adaptation comprend de préférence un système de porte pour isoler le poste de travail.

L'embase modulaire comprend :
- des moyens de raccordement aéraulique des boîtes ;
- des moyens d'ouverture des boîtes pour mettre l'intérieur des boîtes en communication de façon étanche avec le corps ;
- des moyens de positionnement des boîtes sur les moyens d'ouverture des boîtes ; et
- des moyens d'échange d'informations avec les moyens de gestion et de commande.

Pour les boîtes ayant une carte signalétique, l'embase modulaire peut comprendre des moyens de lecture et de mise à jour des informations de cette carte signalétique.

Les moyens de positionnement comprennent de préférence un piston horizontal poussant les boîtes dans un trou d'ancrage.

Les tunnels peuvent comprendre, de préférence, les trois éléments suivants fixés les uns aux autres :
- au moins un module relais constitué d'une section de tunnel ;
- au moins deux modules robots chacun fixé à la sortie d'un poste de travail et à un module de transfert pour transférer les objets plats placés à la sortie des postes de travail vers un autre module robot à travers un module relais, et
- des moyens de protection des objets alimentés par une source de gaz ultrapropre ou d'azote.

### LISTE DES FIGURES

Le système selon l'invention sera mieux compris à la lecture de la description qui suit et qui est accompagnée de plusieurs figures représentant respectivement :
- figure 1, le système général selon l'invention ;
- figure 2, en coupe, une réalisation d'une interface utilisée dans le système selon l'invention ; et
- figure 3, en vue écorchée, un tunnel de déplacement utilisé dans le système selon l'invention.

### DESCRIPTION DETAILLE D'UN MODE DE REALISATION DE L'INVENTION

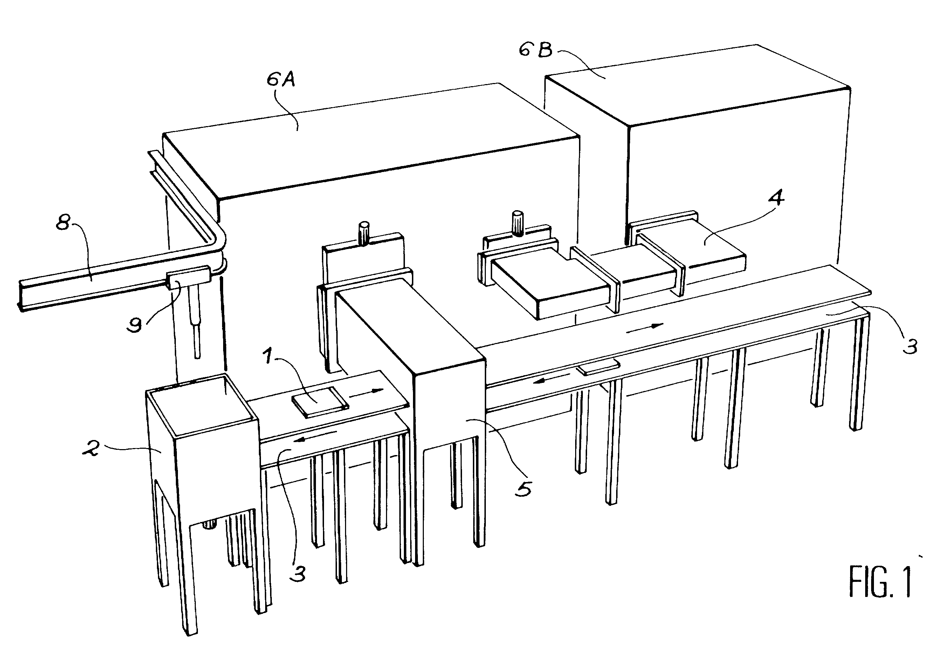

La figure 1 représente deux postes de travail 6A et 6B à l'intérieur desquels sont effectuées des opérations sur des objets plats très fragiles, tels que des plaques de silicium dans des conditions de travail particulières, surtout en ce qui concerne l'atmosphère qui y est souvent spéciale. En dehors de ces postes de travail, les objets sont stockés et manipulés chacun dans une boîte individuelle. Le stockage et le transport de ces boîtes se fait de façon manuelle ou automatique. Par exemple, l'acheminement des objets vers ces postes de travail 6A et 6B peut être assuré par différents éléments, tels que des éléments de déplacement 3 constitués par exemple par un transporteur du type convoyeur à une ou plusieurs voies.

Selon l'invention, des interfaces 5 sont prévus pour faire la transition aéraulique entre ces éléments de déplacement 3 et les postes de travail 6A et 6B.

Les boîtes 1 contiennent chacune un objet plat, tel qu'une plaque de silicium ou un écran plat, qu'elles maintiennent sous atmosphère ultrapropre.

On peut également prévoir que ce type de boîte plate 1 puisse contenir un disque plat, tel qu'un disque compact ou un disque numérique vidéo.

Les objets plats, tels que les plaques de silicium, sont donc ainsi confinés constamment en atmosphère ultrapropre dans leur boîte individuelle 1, et en atmosphère spéciale à l'intérieur des postes de travail 6A et 6B lorsqu'ils sont extraits chacun de leur boîte individuelle 1. Tous ces éléments de confinement sont bien entendus prévus étanches.

Selon l'invention, seul l'intérieur des postes de travail 6A et 6B, des interfaces 5 et des tunnels 4 est maintenu sous atmosphère spéciale, puisque chaque objet plat est enfermé de façon étanche dans sa boîte individuelle 1 lors du stockage et des transports. Lorsque la boîte est ouverte pour l'introduction ou le retrait d'un objet plat, on fait fonctionner un système d'aération interne de la boîte. Une arrivée aéraulique de gaz ultrapropre ou d'azote prévue du côté opposé à la porte de la boîte peut ainsi interdire l'entrée du gaz ambiant par la porte de la boîte.

On est donc en présence d'un système ne mettant en jeu qu'une quantité minimale de volume confiné sous atmosphère ultrapropre ou d'azote et spéciale. De plus, la manipulation des boîtes extraplates 1 s'avère très pratique, puisqu'il est possible de leur donner la forme extérieure standard qu'il convient pour leur manipulation et leur stockage. Pour se faire une idée précise de la facilité d'utilisation de telles boîtes 7, on peut faire une analogie aux boîtes de compact disques.

Ce concept de manutention de tels objets plats, tels que des plaques de silicium dans des boîtes individuelles 1, s'oppose à certains concepts où ces plaques de silicium sont protégées de façon collective, c'est-à-dire jamais entourées d'un étui individuel. Dans le concept de l'invention, l'ensemble objet plat/boîte individuelle 1 constitue un couple indissociable pendant tout le cycle de traitement ou de fabrication de l'objet plat.

Bien entendu, chaque boîte individuelle 1 a une porte escamotable et compatible avec des systèmes d'ouverture et de fermeture conçus dans le système selon l'invention. Ainsi chaque objet peut être extrait et réintroduit dans sa boîte individuelle 1.

Les moyens de gestion et de commande de déplacement de ces boîtes ne sont pas représentés, mais font bien entendu partie du système. Sur cette figure 1 a également été représenté une rampe de manutention 8, horizontale et à laquelle est suspendu un chariot de transport 9 permettant de venir introduire dans un élément de stockage 2 une cassette ou un paquet 7 de boîtes individuelles 1.

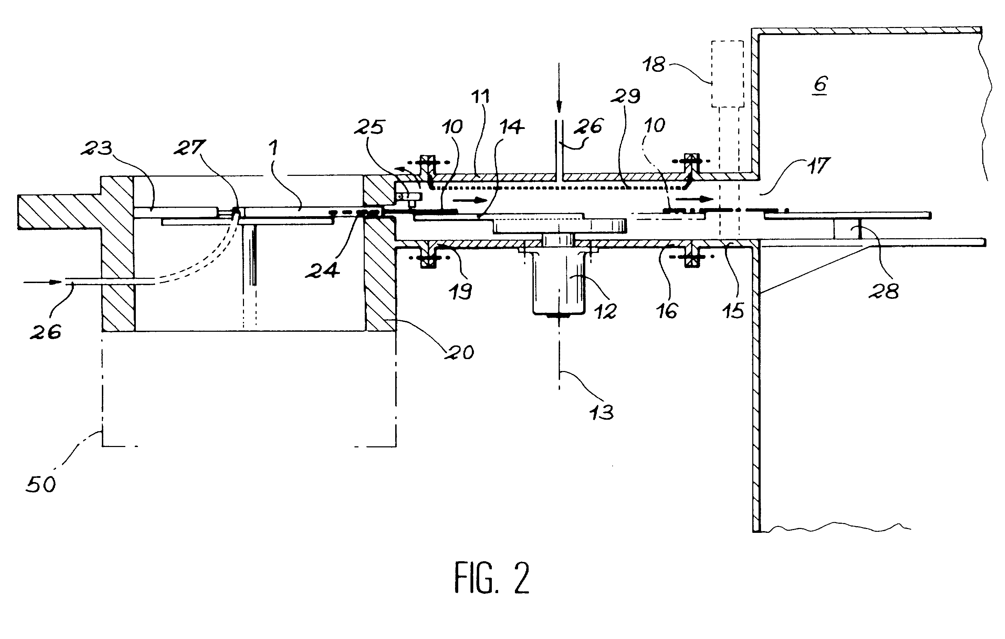

En référence à la figure 2, un des éléments essentiels de l'invention est une interface. Celle-ci fait la transition entre les moyens de transport et les postes de travail.

Une première partie de l'interface est constituée d'un corps 11 qui est une tranche de tunnel devant être traversée par les objets plats 10. Il constitue en sorte une veine d'accès au poste de travail 6. Un tel corps 11 est équipé d'un robot 12, par exemple du type "pick and place", commercialisé par les établissements BROOKS et ADE. Un tel robot 12 sert de relais pour introduire l'objet 10 dans un poste de travail 6. En effet, ce robot 12, par un mouvement de rotation autour d'un axe vertical 13 et un mouvement d'articulation de son bras 14 placé à l'intérieur du corps 11, peut faire traverser le corps 11 à un objet plat 10.

L'objet plat 10 est protégé des contaminations par un balayage permanent, sur tout son trajet à l'intérieur du corps 11, d'air ou d'azote. Ce balayage peut être laminaire, parallèle ou transversal au plan de l'objet plat 10. Le flux d'air peut par exemple être réalisé au moyen d'un diffuseur 29 placé à l'intérieur du corps 11 alimenté par de l'air ultra-pur ou de l'azote 26.

Une autre partie de cette interface est constituée d'une embase d'adaptation 15 fixée à une première extrémité 16 du corps 11. Cette embase 15 est fixée d'autre part à l'entrée 17 d'un poste de travail 6. De préférence, cette embase d'adaptation 15 possède une porte 18 permettant d'isoler le volume interne de ce poste de travail 6 par rapport au volume interne de l'interface. En effet, l'atmosphère de travail n'est généralement pas ultrapropre mais spéciale. Il est donc nécessaire de purger le volume de l'interface pour le remplir de cette atmosphère spéciale avant l'ouverture de cette porte 18.

La troisième partie de cette interface est constituée d'une embase modulaire 20 fixée à la deuxième extrémité 19 du corps 11. Elle comprend principalement des moyens de raccordement aéraulique des boîtes, des moyens de positionnement de ces boîtes, des moyens d'ouverture des boîtes et des moyens d'échange d'informations avec les moyens de gestion et de commande.

Bien qu'il soit possible de charger manuellement les boîtes 1 sur l'embase modulaire 20, celle-ci est usuellement placée sur le trajet des moyens de déplacement des boîtes, dans le but d'intercepter celles dont les objets qu'elles contiennent doivent subir le traitement prévu dans le poste de travail correspondant. Cette embase 20 est alors montée sur un module spécial du système de déplacement permettant d'extraire automatiquement les boîtes 1 du système de convoyage. L'embase modulaire 20 associée au module spécial 50 constitue un élément intermédiaire dans les moyens de déplacement des boîtes.

Pour constituer des moyens de positionnement des boîtes 1, on prévoit un piston horizontal 23 pour pousser alors la boîte 1 vers un trou d'ancrage et de positionnement 24. La porte d'ouverture de la boîte 1 est alors mise en contact avec la porte de fermeture 19 de l'embase modulaire 20. On prévoit des moyens d'ouverture simultanée des deux portes afin d'emprisonner les contaminations présentes à l'interface. Cette ouverture permet de mettre en communication le volume interne de la boîte 1 avec le volume interne du corps 11. Un flux d'air pur ou d'azote est établi progressivement dans la boîte 1 pendant cette ouverture afin de protéger l'objet 10 de toutes les sources possibles de contamination. Un régime aéraulique est établi entre la boîte 1 et le corps 11 afin de garantir la protection de l'objet 10 pendant toute la durée de son transfert sur le poste de travail. Ces moyens d'ouverture peuvent être constitués par un dispositif, référencé 25, placé à l'extrémité de l'embase modulaire 20, au-dessus ou au-dessous du trou d'ancrage 24. L'ouverture des deux portes, rendues solidaires, peut se faire par pivotement ou translation.

L'embase modulaire 20 peut également comprendre des moyens d'échange d'informations avec les moyens de commande. En effet, dans le cas où les boîtes 1 ont chacune une carte signalétique, on peut prévoir des moyens de lecture et de mise à jour des informations contenues dans la carte signalétique de la boîte 1. Ces moyens peuvent être placés sur le piston horizontal 23 pour pouvoir être en communication avec l'arrière de la boîte 1.

Les boîtes 1 ayant des moyens de ventilation interne, l'embase modulaire 20 comprend des moyens de raccordement aéraulique à ces boîtes 1. Ces moyens de raccordement aéraulique peuvent être réalisés sous la forme d'une arrivée de gaz ultrapropre ou d'azote 26 pouvant être connecté au moyen de ventilation interne des boîtes 1. Une connexion aéraulique 27 de l'arrivée 26 est fixée sur le piston 23 et peut être plaquée contre une entrée aéraulique de la boîte 1.

Le fonctionnement de l'interface ainsi décrite est le suivant. La boîte 1 est positionnée automatiquement ou manuellement autour du trou d'ancrage 24. Le piston horizontal 23 pousse alors la boîte 1 dans le trou d'ancrage 24 jusqu'à ce que celle-ci prenne une position déterminée en translation qui peut être définie par la course du piston horizontal 23.

L'ouverture de la boîte 1 peut alors avoir lieu au moyen du système 25 qui saisit par encliquetage la porte de la boîte 1. Un pivotement de ce système d'ouverture 25 met ainsi en communication le volume interne de la boîte 1 avec le volume interne du corps 11. L'intérieur de la boîte 1 est alors mis sous circulation aéraulique grâce à la connexion 27.

Le robot 12 peut alors saisir par son bras 14 équipé de moyens de préhension l'objet plat 10 contenu à l'intérieur de la boîte 1. Une rotation autour de l'axe vertical 13 du robot 12 et/ou une articulation du bras 14 permet de positionner l'objet plat sur un support 28 placé à l'entrée du poste de travail. L'opération inverse peut également avoir lieu pour replacer l'objet à l'intérieur de la boîte individuelle 1, celle-ci étant refermée.

On conçoit ainsi qu'une telle embase modulaire permette de construire un interface pouvant assurer diverses fonctions :
- la comptabilité des boîtes 1 gérée par le système ;
- l'encliquetage de la boîte 1 sur les moyens d'ouverture 25 ;
- le raccordement aéraulique de chaque boîte 1 avec le réseau de distribution d'air pur ou d'azote ;
- le contrôle éventuel de certains paramètres physico-chimiques à l'intérieur de la boîte 1 ;
- le mécanisme d'ouverture et de fermeture de la boîte 1 ;
- la commande du transfert de la plaque de silicium de la boîte 1 vers le poste de travail 6 ; et
- des échanges d'informations avec le système de commande et avec un éventuel système de distribution automatique des boîtes.

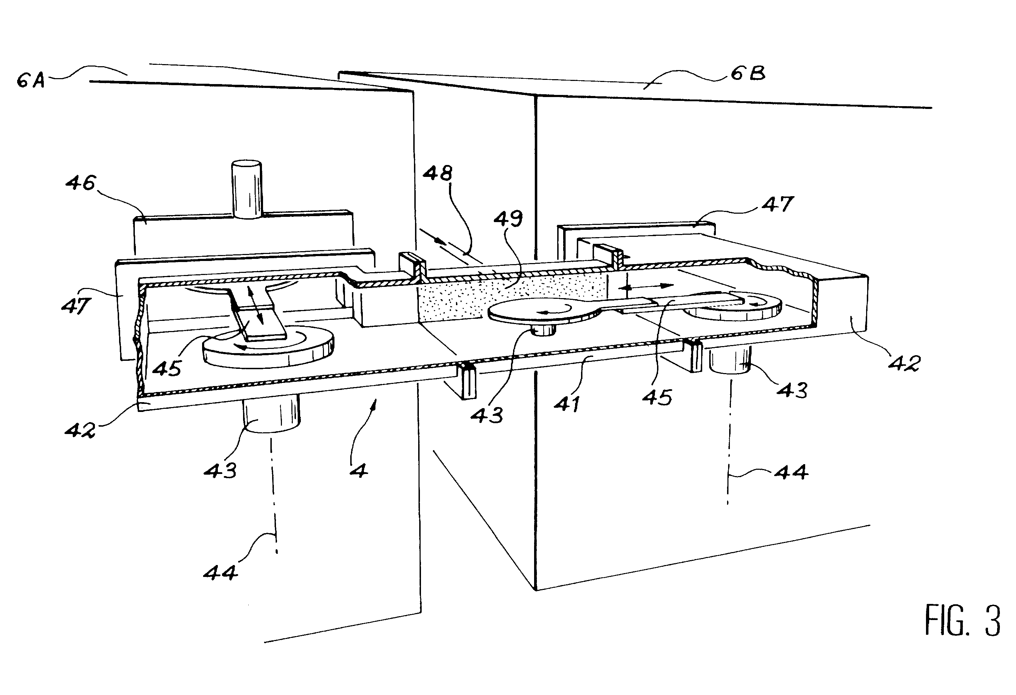

La figure 3 détaille une réalisation d'un tunnel 4 du système selon l'invention. Un tel tunnel est réalisé à partir de deux types de modules de base qui sont deux modules corps en équerre 42 entre lesquels est placé un module relais 41. Comme le montre la figure 3, chaque module corps en équerre 42 est fixé à un poste de travail 6A ou 6B par l'intermédiaire de moyens de moyens de fixation 47 adaptés à l'entrée de ces postes de travail 6A et 6B. Ces moyens de fixation peuvent être complétés d'un système de porte 46 destiné à isoler, soit le tunnel 4, soit le poste de travail 6A ou 6B de manière analogue au système de porte utilisé dans l'embase de l'interface. Ainsi, le tunnel 4 ou le ou les postes de travail 6A et 6B peuvent être isolés les uns des autres du point de vue de l'aéraulique. Si la distance entre les portes 6A et 6B est importante, il est possible de rallonger le tunnel 4 en utilisant des modules corps 11 décrits précédemment, que l'on dénommera dans cette application par module corps "droit". Un module relais 41 est indispensable entre deux modules corps.

L'objet plat 10 est protégé de la contamination lorsqu'il est transféré à l'intérieur du tunnel 4 par les différents robots "pick and place" 43, équipant les modules corps 11 ou 42, par un balayage permanent d'air ou d'azote. Les modules corps 11 et 42 et relais 41 sont équipés d'un dispositif aéraulique assurant cette protection. Ce dispositif peut être composé d'un diffuseur 49 placé parallèlement ou perpendiculairement à l'objet et alimenté en air ultra-pur ou en azote par une arrivée aéraulique 48. Ces dispositifs sont étudiés de façon à ce qu'aucune turbulence n'existe aux différents interfaces.

Le tunnel 4 a été représenté de manière écorchée pour montrer l'intérieur de celui-ci. On distingue ainsi à l'intérieur de chacun des modules corps en équerre 42 un robot 43 analogue à celui installé dans le corps de l'interface. Chaque robot est du type "pick and place". En d'autres termes, il permet un mouvement de rotation autour d'un axe vertical 44 et des mouvements de translation horizontaux. Ainsi, si chacun des modules corps en équerre 42 est constitué d'une section de tunnels formant un angle droit, on comprend que chacun de ces robots puisse transférer un objet plat de l'intérieur d'un poste de travail 6A ou 6B vers le module relais 41. Il suffit pour cela de saisir l'objet plat par l'extrémité du bras 45, ramener l'objet plat vers le centre du robot, d'effectuer une rotation de 90°, de rallonger le bras 45 en direction du module relais 41 où il peut être posé sur un support 48 du module relais 41. Les plaques de silicium peuvent ainsi être transférées facilement d'un poste de travail 6A vers un autre poste de travail 6B. On peut également intercaler des modules relais 41 avec des modules tels que des corps 11 de l'interface de la figure 2 pour constituer une portion de tunnel plus longue.

Ainsi, deux postes de travail 6A et 6B peuvent être associés de manière dite "rigide". Il est donc possible de réaliser facilement des tunnels actifs à l'intérieur desquels circule de l'air ultrapropre ou de l'azote. Il est même possible de prévoir des tunnels capables de supporter un vide partiel. En effet, en dotant le système de pompes et en assurant une étanchéité de haut niveau, il est possible d'envisager pour ce système des applications aux traitements et/ou fabrications sous vide.

Le système selon l'invention a été décrit dans sa réalisation destinée aux plaques de silicium qui requiert des conditions de propreté extrême. De manière générale, le système selon l'invention peut être utilisé pour la manutention d'objets plats, même de grande dimension et requérant éventuellement des conditions de propreté et de pureté équivalente. C'est le cas des écrans plats. L'application à des compacts disques peut également rentrer dans les applications d'un tel système selon l'invention.

En utilisant des éléments de fermeture étanches, on peut envisager l'application du système selon l'invention pour manipuler des objets sous vide.

## Revendications

1. Système de manipulation de plaques de silicium (10) confinés chacune sous atmosphère ultrapropre dans une boîte individuelle (1) pour amener ces plaques (10) à l'intérieur d'au moins un poste de travail (6, 6A, 6B) où se trouve une atmosphère ultrapropre, comprenant :
- des boîtes individuelles (1) dans lesquelles se trouve une atmosphère ultrapropre chaque boîte (1) étant extraplate et possèdant une porte escamotable ;
- des moyens de déplacement (3) des boîtes dans une atmosphère ordinaire ;
- des moyens de gestion et de commande des déplacements des boîtes;
- des interfaces (5) entre les moyens de déplacement (3) et les postes de travail (6, 6A, 6B) des plaques (10) dans lesquels les plaques (10) sont extraites des boîtes (1) et sont maintenues sous atmosphère ultrapropre pendant toute la durée où ils restent à l'intérieur des postes de travail (6, 6A, 6B), chaque interface (5) comprenant :
- un corps (11) constituant une veine d'accès, équipé d'un robot (12) du type "pick and place" agissant à l'intérieur de cette veine pour faire traverser celle-ci à une plaque (10) ;
- une embase d'adaptation (15) fixée, d'une part à une première extrémité (16) du corps (11) et d'autre part à l'entrée (17) d'un poste de travail (6) assurant le positionnement mécanique de l'interface (5) par rapport au poste de travail (6) ; et
- une embase modulaire (20) pour positionner les boîtes (1), les ouvrir et permettre au robot (12) de saisir les plaques (10) et pour effectuer les opérations inverses ;
- l'embase modulaire (20) comprenant :
. des moyens de raccordement aéraulique (26, 27) des boîtes (1) pour introduire une atmosphère ultrapropre ;
. des moyens d'ouverture (25) des boîtes (1) pour mettre l'intérieur de ces boîtes (1) de façon étanche en communication avec le corps (11) ;
. des moyens de positionnement (24) des boîtes (1) sur les moyens d'ouverture (25) ; et
. des moyens d'échange d'informations avec les moyens de gestion et de commande ; et
- des tunnels de transfert (4) des plaques (1) pour raccorder de façon rigide deux postes de travail (6A, 6B) tout en maintenant ces plaques sous atmosphère ultrapropre.

2. Système selon la revendication 1, caractérisé en ce que le corps (11) comprend des moyens de protection des plaques (10) alimentée par une arrivée d'air ultrapropre ou d'azote (26).

3. Système selon la revendication 1, caractérisé en ce que l'embase d'adaptation (15) comporte un système de porte (18) pour isoler le poste de travail (6) du corps (11).

4. Système selon la revendication 1, les boîtes (1) ayant une carte signalétique, caractérisé en ce qu'il comprend des moyens de lecture et de mise à jour des informations de cette carte signalétique.

5. Système selon la revendication 1, caractérisé en ce que les moyens de positionnement comprennent un piston horizontal (23) destiné à pousser les boîtes (1) dans un trou d'ancrage (24).

6. Système selon la revendication 1, caractérisé en ce que chaque tunnel (4) comprend :
- au moins un module relais (14) constitué d'une section de tunnel ;
- au moins deux modules corps en équerre (42) chacun fixé à la sortie d'un poste de travail (6A, 6B) et à un module relais (41) pour transférer les plaques placés à la sortie des postes de travail (6A, 6B) vers un autre module robot à travers un module relais (41) ; et
- des moyens de protection des plaques (10), ces moyens étant alimentés par une arrivée d'air ultrapropre ou d'azote (48).

## Patentansprüche

1. Handhabungssystem für Siliciumscheiben (10), jede in ultrareiner Atmosphäre eingeschlossen in einen Einzelbehälter (1), um diese Scheiben (10) ins Innere von wenigstens einer Bearbeitungsstation (6, 6A, 6B) zu bringen, in der eine ultrareine Atmosphäre herrscht, umfassend:
- Einzelbehälter (1), in denen eine ultrareine Atmosphäre herrscht, wobei jeder Behälter (1) extra-flach ist und eine weg- bzw. aufklappbare Tür umfaßt;
- Verschiebungseinrichtungen (3) der Behälter in einer gewöhnlichen Atmosphäre;
- Verwaltungs- und Steuereinrichtungen der Behälterverschiebungen;
- Schnittstellen-Vorrichtungen (5) zwischen den Verschiebungseinrichtungen (3) und den Bearbeitsstationen (6, 6A, 6B) der Scheiben (10), in denen die Scheiben (10) aus den Behältern (1) entnommen werden und während der gesamten Dauer ihres Aufenthalts im Innern der Bearbeitungsstationen (6, 6A, 6B) unter ultrareiner Atmosphäre gehalten werden, wobei jede Schnittstelle (5) umfaßt:
- ein Gehäuse (11), einen Zugang bildend, in seinem Innern ausgestattet mit einem Roboter (12) des Typs "pick and place", mit dessen Hilfe die Scheiben (10) dieses Gehäuse durchqueren;
- einen Anpassungsansatz (15), einerseits an einem ersten Ende (16) des Gehäuses (11) befestigt und andererseits am Eingang (17) einer Bearbeitungsstation (6), der die mechanische Positionierung der Schnittstellen-Vorrichtung (5) in bezug auf die Bearbeitungsstation (6) sichert; und
- einen modularen Ansatz (20), umfassend:
. hydraulische Anschlußeinrichtungen (26, 27) der Behälter (1) zum Einleiten einer ultrareinen Atmosphäre;
. Öffnungseinrichtungen (25) der Behälter (1), damit das Innere dieser Behälter (1) auf dichte Weise mit dem Gehäuse (11) kommuniziert;
. Einrichtungen (24) zum Positionieren der Behälter (1) auf den Öffnungseinrichtungen (25);
. Einrichtungen zum Austauschen von Informationen mit den Verwaltungs- und Steuereinrichtungen; und
. Transfertunnels (4) der Scheiben (1), um zwei Bearbeitungsstationen (6A, 6B) auf dichte Weise zu verbinden und dabei die ultrareine Atmosphäre in diesen Behältern aufrechtzuerhalten.

2. System nach Anspruch 1, dadurch gekennzeichnet, daß das Gehäuse (11) Schutzeinrichtungen der Scheiben (10) mit einer Zuführung (26) von ultrareiner Luft oder von Stickstoff umfaßt.

3. System nach Anspruch 1, dadurch gekennzeichnet, daß der Anpassungsansatz (15) ein Tür-System (18) umfaßt, um die Arbeitsstation (6) von dem Gehäuse (11) zu trennen.

4. System nach Anspruch 1, wobei die Gehäuse eine Signalisierungskarte haben, dadurch gekennzeichnet, daß es Lese- und Aktualisierungseinrichtungen dieser Signalisierungskarte umfaßt.

5. System nach Anspruch 1, dadurch gekennzeichnet, daß die Positionierungseinrichtungen einen horizontalen Kolben (23) umfassen, dazu bestimmt, die Gehäuse (1) in ein Verankerungsöffnung (24) zu schieben.

6. System nach Anspruch 1, dadurch gekennzeichnet, daß jeder Tunnel (4) umfaßt:
- wenigstens einen Relaismodul (41), gebildet durch eine Tunnelsektion;
- wenigstens zwei winkelförmige Gehäusemodule (42), jeder befestigt am Ausgang einer Bearbeitungsstation (6A, 6B) und an einem Relaismodul (41), um die am Ausgang der Bearbeitungsstationen (6A, 6B) abgelegten Scheiben durch einen Relaismodul (41) hindurch zu einem anderen Robotermodul zu befördern; und
- Schutzeinrichtungen der Scheiben (10), wobei diese Einrichtungen durch eine Zuführung (48) mit ultrareiner Luft oder Stickstoff versorgt werden.

## Claims

1. System for handling silicon wafers (10), each confined under an ultraclean atmosphere in an individual box (1) in order to bring said wafers (10) into the interior of at least one working station (6, 6A, 6B) where there is an ultraclean atmosphere comprising:
- individual boxes (1) in which there is an ultraclean atmosphere,
- each box (1) is ultraflat and has a concealable door,
- means (3) for moving the boxes into an ordinary atmosphere,
- means for the management and control of the movement of the boxes,
- interfaces (5) between the displacement means (3) and the working stations (6, 6A, 6B) for the wafers (10), in which the wafers (10) are extracted from the boxes (1) and maintained under an ultraclean atmosphere for the entire period during which they remain within the working stations (6, 6A, 6B), each interface (5) comprising:
- a body (11) constituting an access tunnel, equipped with a pick and place robot (12) acting within said tunnel in order to make a wafer (10) pass through the latter,
- an adapting bottom plate (15) fixed, on the one hand to a first end (16) of the body (11) and on the other to the inlet (17) of a working station (6) ensuring the mechanical positioning of the interface (5) relative to the working station (6) and
- a modular base (20) for positioning the boxes (1), for opening them and enabling the robot (12) to grasp the wafers (10) and perform the reverse operations,
- the modular base (20) comprising:
- means (26, 27) for the aeraulic connection of the boxes (1) for introducing an ultraclean atmosphere,
- means (25) for opening the boxes (1) in order to bring the interior of said boxes (1) into tight communication with the body (11),
- means (24) for positioning the boxes (1) on the opening means (25),
- means for the exchange of information with the management and control means and
- tunnels (4) for the transfer of wafers (1) for the rigid connection of two working stations (6A, 6B), whilst maintaining the wafers under the ultraclean atmosphere.

2. System according to claim 1, characterized in that the body (11) comprises means for protecting the wafers (10) supplied by a nitrogen ultraclean air feed pipe (26).

3. System according to claim 1, characterized in that the adapting bottom plate (15) has a door system (18) for isolating the working station (6) from the body (11).

4. System according to claim 1, the boxes (1) having a descriptive card, characterized in that it comprises means for reading an dupdating the information on said descriptive card.

5. System according to claim 1, characterized in that the positioning means incorporate a horizontal piston (23) for pushing the boxes (1) into an anchoring hole (24).

6. System according to claim 1, characterized in that each tunnel (4) comprises at least one relay module (41) constituted by a tunnel section and at least two cornering modules (42), each fixed to the outlet of a working station (6A, 6B) and to a relay module (41) for transferring the wafers positioned at the outlet of the working stations (6A, 6B) to another robot module across a relay module (41) and means for protecting the wafers (10), said means being supplied by an ultraclean air or nitrogen feed pipe (48).
